Europäisches Patentamt

European Patent Office

Office européen des brevets

(11) Veröffentlichungsnummer: **0 404 987**

**A1**

(12) # EUROPÄISCHE PATENTANMELDUNG

(21) Anmeldenummer: 89111873.9

(22) Anmeldetag: 29.06.89

(51) Int. Cl.5: **H01L 31/0224, H01L 31/105**

(43) Veröffentlichungstag der Anmeldung:
**02.01.91 Patentblatt 91/01**

(84) Benannte Vertragsstaaten:
**AT BE CH DE ES FR GB GR IT LI LU NL SE**

(71) Anmelder: **Siemens Aktiengesellschaft**
**Wittelsbacherplatz 2**
**D-8000 München 2(DE)**

(72) Erfinder: **Jakowetz, Wolf, Dr. rer.nat.**
**Starenweg 21**
**D-8011 Vaterstetten(DE)**
Erfinder: **Schäfer, Herbert, Dr. rer.nat.**
**Unterhachinger Strasse 87a**
**D-8000 München 83(DE)**
Erfinder: **Osojnik, Karl, Dipl.-Ing.**
**Johann-Clanze-Strasse 31a**
**D-8000 München 70(DE)**

(54) **Ohmscher Kontakt für eine p-leitende Schicht eines InP-Substrates von Fotodioden und Verfahren zu dessen Herstellung.**

(57) Ein Kontakt für eine p-leitende Schicht (5) eines InP-Substrates (1) von Fotodioden mit einer (In, Ga)-(As,P)/InP-oder einer (In,Ga)As/InP- Heteroschichtstruktur soll ein ohmsches Verhalten besitzen, ohne die gute Passivierbarkeit des Bauelements und die Transparenz für die zu detektierende Strahlung negativ zu beeinträchtigen. Zwischen dem p-Kontakt (11) und einem $p^+$-dotierten Gebiet (7) der p-leitenden Deckschicht (5) ist eine p-leitende InGaAs- oder InGaAsP-Zwischenschicht vorgesehen, die Teil der Schichtstruktur (4) oder eine zusätzlich eingebrachte Schicht ist.

Ein erfindungsgemäßer ohmscher Kontakt findet insbesondere bei Fotodioden für den Wellenlängenbereich von 1µm bis 1,6µm Anwendung.

FIG 3

EP 0 404 987 A1

## OHMSCHER KONTAKT FÜR EINE P-LEITENDE SCHICHT EINES INP-SUBSTRATES VON FOTODIODEN UND VERFAHREN ZU DESSEN HERSTELLUNG.

Die Erfindung betrifft einen ohmschen Kontakt für eine p-leitende Schicht eines InP-Substrates von Fotodioden nach dem Oberbegriff des Anspruchs 1 und ein Verfahren zu dessen Herstellung.

Halbleiterbauelemente benötigen zu Betrieb elektrische Kontakte, durch die Versorgungs- und Signalspannungen zu- oder abgeführt werden müssen. In den meisten Fällen ist es wichtig, daß diese Kontakte ein ohmsches Verhalten zeigen, damit die Funktion des Bauelementes nicht beeinflußt wird.

Das elektrische Verhalten von Metall-Halbleiter-Kontakten hängt von den Materialien und vom Herstellungsprozeß ab. Im Halbleitersystem InP/InGaAsP oder InP/InGaAs, das für optoelektronische Bauelemente, wie z.B. Fotodioden, im Wellenlängenbereich von 1μm bis 1,6μm angewendet wird, ist besonders das Herstellen von ohmschen Kontakten auf p-leitendem Indiumphosphid (InP) sehr schwierig.

Bei herkömmlichen Fotodioden werden entweder legierbare p-Kontakte auf InP verwendet, oder es werden p-Kontakte akzeptiert, die kein rein ohmsches Verhalten zeigen. Im ersten Fall besteht die Gefahr, daß Metallionen aus dem p-Kontakt bis zur aktiven Schicht vordringen und unerwünschte Effekte, wie z.B. eine vorzeitige Degradation auslösen; im letzteren Fall sind Beschränkungen in der Anwendbarkeit die Folge.

Der Erfindung liegt die Aufgabe zugrunde, einen p-Kontakt für eine p-leitende Schicht eines InP-Substrates von Fotodioden zu schaffen, der sich durch sein ohmsches Verhalten auszeichnet, wobei die p-leitende inP-Schicht, die außerhalb des Kontaktbereiches an der Oberfläche liegt, die gute Passivierbarkeit des Bauelementes und die Transparenz für die zu detektierende Strahlung gewährleisten soll, die erst in der aktiven Schicht absorbiert werden soll.

Diese Aufgabe wird erfindungsgemäß durch einen ohmschen Kontakt mit den Merkmalen des Anspruchs 1 und ein Verfahren mit den Merkmalen der Ansprüche 2 und 3 gelöst.

Bei der Realisierung der Erfindung wird die an sich bekannte Tatsache ausgenutzt, daß sich p-Kontakte auf p-leitendem InGaAsP und InGaAs wesentlich leichter herstellen lassen als auf InP. Dies ist sogar möglich mit Kontaktmetallisierungen, die nicht einlegiert werden müssen und bei denen folglich auch nicht das Risiko der Eindiffusion besteht.

Ein erfindungsgemäßer ohmscher Kontakt wird entweder dadurch realisiert, daß man eine zusätzliche InGaAs- oder InGaAsP-Schicht epitaktisch aufbringt und diese so strukturiert, daß sie nur unter dem Kontakt stehen bleibt, außerhalb des Kontaktes wird diese Schicht entfernt, um eine Absorption der zu detektierenden Strahlung an der Oberfläche zu vermeiden, oder die InP-Deckschicht wird unter dem Kontakt entfernt. In beiden Fällen wird der p-Kontakt dann zum p-leitenden InGaAs oder InGaAsP hergestellt, wodurch ein ohmsches Verhalten leicht erreicht wird. Trotzdem gewährleistet die InP-Schicht, die außerhalb des Kontaktbereiches an der Oberfläche liegt, die gute Passivierbarkeit des Bauelementes und die Transparenz für die zu detektierende Strahlung, die erst in der aktiven Schicht absorbiert werden soll.

Anhand der Figuren der Zeichnung wird die Erfindung im folgenden näher erläutert. Es zeigen:
FIG 1 den Schichtaufbau einer herkömmlichen InGaAsP-Fotodiode
FIG 2 und 3 Ausführungsbeispiele von InGaAsP-Fotodioden mit ohmschem p-Kontakt.

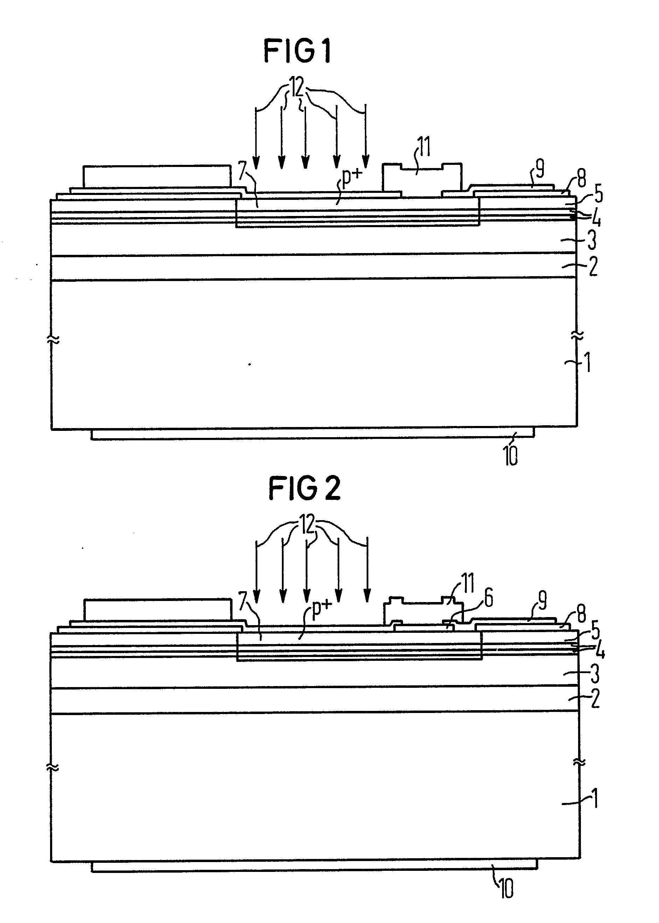

In FIG 1 ist ein möglicher Schichtaufbau einer herkömmlichen InGaAsP-Fotodiode dargestellt. Auf dem InP-Substrat 1 werden nacheinander eine InP-Pufferschicht 2, eine InGaAs aktive schicht 3 und eine InP-Deckschicht 5 gitterangepaßt aufgewachsen. Im Falle der Flüssigphasenepitaxie werden noch zusätzlich eine oder mehrere, in diesem Beispiel zwei, InGaAsP-Rücklöseschutzschichten 4 aufgewachsen. Im Herstellungsprozeß wird das $p^+$-dotierte Gebiet 7 definiert, die Oberfläche mit einer Passivierung 8 und einer Antireflexschicht 9 abgedeckt und das Bauelement mit dem n-Kontakt 10 und dem p-Kontakt 11 versehen. Der p-Kontakt 11 ist dabei, wie eingangs beschrieben, entweder einlegiert, oder er besitzt kein rein ohmsches Verhalten.

Bei dem in FIG 2 dargestellten Ausführungsbeispiel weist die Fotodiode eine zu der in FIG 1 dargestellten Diode analoge Schichtenfolge bzw. (In, GA)(As, P)/InP-Heteroschichtstruktur auf mit dem erfindungsgemäßen Unterschied, daß auf das $p^+$-dotierte Gebiet der p-leitenden Deckschicht 5 des InP-Substrates 1 als Zwischenschicht eine p-leitende InGaAs-Schicht 6 epitaktisch aufgebracht und so strukturiert ist, daß diese nur unter dem p-Kontakt stehen bleibt, und so den Kontaktübergang vom $p^+$-dotierten Gebiet zum p-Kontakt 11 bildet.

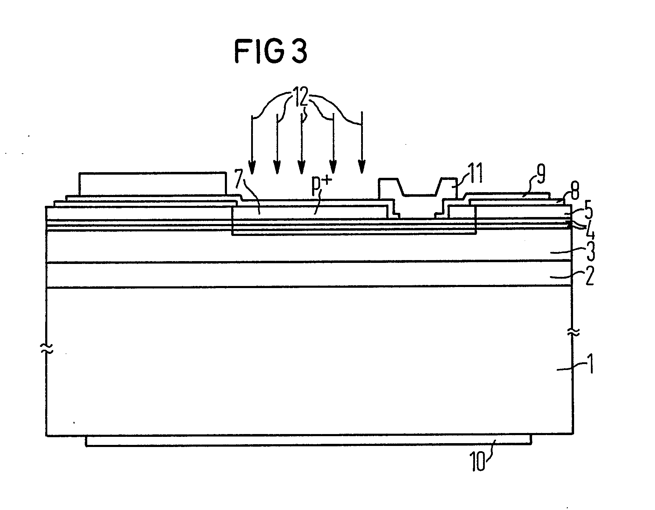

Bei dem in FIG 3 dargestellten Ausführungsbeispiel weist die Fotodiode wiederum die in FIG 1 gezeigte InGaAsP/InP-Heteroschichtenstruktur auf. Der erfindungsgemäße Unterschied besteht bei dieser Ausführungsform darin, daß die p-leitende InP-Deckschicht 5 unter dem p-Kontakt 11 vor dessen Aufbringen entfernt worden ist. Der p-Kontakt 11 füllt nach seinem Aufbringen diesen Freiraum aus und reicht durch die InP-Deckschicht hindurch bis zur angrenzenden herkömmlichen InGaAsP Rücklöseschutzschicht 4, die nunmehr die Funktion der Zwischenschicht übernimmt und den Kontaktübergang vom p-Kontakt 11 zum $p^+$-dotierten Gebiet der p-leitenden InP-Schicht 5 herstellt, so daß dieser p-Kontakt beim Betrieb der Fotodiode ein rein ohmsches Verhalten zeigt.

Die InP-Schicht 5, 7, die außerhalb des Bereiches des p-Kontaktes 11 an der Oberfläche liegt, gewährleistet die gute Passivierungsschicht 8 und die Transparenz für die zu detektierende Strahlung 12, die erst in der aktiven Schicht, d.h. der InGaAs-Schicht 3, absorbiert werden soll.

## Ansprüche

1. Ohmscher Kontakt für eine p-leitende Schicht eines InP-Substrates von Fotodioden mit einer (InP, GA)(As, P)/InP-oder einer (In, Ga)As/InP-Heteroschichtstruktur, **dadurch gekennzeichnet**, daß zwischen dem p-Kontakt (11) und einem $p^+$-dotierten Gebiet (7) der p-leitenden Deckschicht (5) eine p-leitende InGaAs- oder InGaAsP-Zwischenschicht vorgesehen ist, die Teil der Schichtstruktur (4) oder eine zusätzlich eingebrachte Schicht (6) ist.

2. Verfahren zum Herstellen eines ohmschen Kontaktes nach Anspruch 1, **dadurch gekennzeichnet**, daß auf das $p^+$-dotierte Gebiet (7) der p-leitenden Schicht (5) des InP-Substrates (1) als Zwischenschicht eine p-leitende InGaAs- oder InGaAsP-Schicht (6) epitaktisch aufgebracht und so strukturiert wird, daß diese nur unter dem p-Kontakt (11) stehen bleibt.

3. Verfahren zum Herstellen eines ohmschen Kontaktes nach Anspruch 1, **dadurch gekennzeichnet**, daß die p-leitende InP-Deckschicht (5) unter dem p-Kontakt (11) vor dessen Aufbringen entfernt wird, und daß der p-Kontakt (11) den entstandenen Freiraum ausfüllend bis zu dem eine p-leitende InGaAs- oder InGaAsP-Zwischenschicht (4) bildenden Teil der Schichtstruktur (3, 4) reichend einge-bracht wird.

89 P 1 5 4 6 E

# FIG 1

# FIG 2

# FIG 3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | IEEE ELECTRON DEVICE LETTERS, Band EDL-6, Nr. 2, Februar 1985, Seiten 78-80, New York, US; C.C. SHEN et al.: "High conversion efficiency p-n+ InP homojunction solar cells" * Das ganze Dokument * --- | 1,2 | H 01 L 31/022 H 01 L 31/105 |
| X | PATENT ABSTRACTS OF JAPAN, Band 12, Nr. 232 (E-628)[3079], 30. Juni 1988; & JP-A-63 25 985 (FUJITSU LTD) 03-02-1988 * Das ganze Dokument * --- | 1,3 | |
| X | PATENT ABSTRACTS OF JAPAN, Band 9, Nr. 332 (E-370)[2055], 26. Dezember 1985; & JP-A-60 163 471 (NIPPON DENKI K.K.) 26-08-1985 * Das ganze Dokument * --- | 1,3 | |
| X | WO-A-8 806 350 (BT & D TECHNOLOGIES LTD) * Seite 4, Zeile 9 - Seite 7, Zeile 17; Ansprüche 1-7; Figuren 1-6 * --- | 1,3 | RECHERCHIERTE SACHGEBIETE (Int. Cl.5) |
| A | APPLIED PHYSICS LETTERS, Band 48, Nr. 21, 26. Mai 1986, Seiten 1416-1418, New York, US; W.T. TSANG et al.: "InGaAs/InP p-i-n- photodiodes grown by chemical beam epitaxy" * Das ganze Dokument * --- | 1,2 | H 01 L |
| A | ELECTRONICS LETTERS, Band 22, Nr. 17, 14. August 1986, Seiten 905-906, Stevenage, Herts, GB; J.E. BOWERS et al.: "High-speed zero-bias waveguide photodetectors" ----- | | |

Der vorliegende Recherchenbericht wurde für alle Patentansprüche erstellt

| Recherchenort | Abschlußdatum der Recherche | Prüfer |
|---|---|---|
| DEN HAAG | 07-03-1990 | VISENTIN A. |